Europäisches Patentamt

European Patent Office

Office européen des brevets

(19)

(11) Publication number: **0 064 288**
**A1**

(12) **EUROPEAN PATENT APPLICATION**

(21) Application number: 82103729.8

(22) Date of filing: 30.04.82

(51) Int. Cl.³: **C 23 C 11/00**
C 23 C 13/00, C 23 C 15/00
H 01 J 27/08, H 01 J 27/16
H 05 H 1/26, H 05 H 3/02

(30) Priority: 04.05.81 US 260359

(43) Date of publication of application:
10.11.82 Bulletin 82/45

(84) Designated Contracting States:
AT BE CH DE FR GB IT LI LU NL SE

(71) Applicant: OPTICAL COATING LABORATORY, INC.
2789 Northpoint Parkway
Santa Rosa, CA 95401(US)

(72) Inventor: Van Cakenberghe, Jean L.
17 Zavelstraat
B-1650 Beersel(BE)

(74) Representative: Ebbinghaus, Dieter et al,
K.L. Schiff Dr. A. von Funer Dipl.-Ing. P. Strehl Dr. U.
Schübel-Hopf Dipl.-Ing. D. Ebbinghaus Dr. Ing. D. Finck
Patentanwälte Mariahilfplatz 2 & 3
D-8000 München 90(DE)

(54) Method and apparatus for the production and utilization of activated molecular beams.

(57) Apparatus and method for producing an activated gas plasma in an evacuated working chamber (10). A substantially closed source chamber (20) is mounted adjacent one wall (11) of a working chamber (10) and has a small aperture nozzle (22) extending through the wall (11) to communicate gas between the source chamber (20) and the working chamber (10). A selected gas is supplied to the source chamber (20) at a pressure substantially greater than the pressure in the working chamber (10) to produce a high velocity stream of gas entering the working chamber (10) through the nozzle (22). The selected gas is activated in the source chamber (20) before exiting through the nozzle (22) so that a high velocity stream of activated gas molecules is produced. An anode (12) is positioned within the working chamber (10) to produce a continuous gas discharge in the activated gas plasma. Various exemplary applications for enhancing chemical reactions within the working chamber (10) are discussed. In one version of the invention an elongated magnetic field is used to confine the plasma stream to a narrow beam and an anode is provided for producing a sustained gas discharge in the confined plasma stream. Further magnetic field arrangements (160, 170) are provided to configure and/or direct the plasma beam to impinge on one or more work pieces, evaporation source, or substrates.

FIG.—1

- 1 -

METHOD AND APPARATUS FOR THE PRODUCTION
AND UTILIZATION OF ACTIVATED MOLECULAR BEAMS

This application is a continuation-in-part of my co-pending application Serial No. 260,359, filed May 4, 1981.

This invention relates generally to methods and apparatus for the production and utilization of activated molecular beams and, more specifically, to methods and apparatus for the production and utilization of activated molecular beams to produce accelerated chemical reactions at reduced pressure and/or to do other work, e.g. to heat a target element for purposes of heat treatment, melting and/or vaporization.

Activated molecular beams may be utilized to accelerate chemical reactions in evacuated chambers in a number of applications. Use of the term "activated" is intended to include electrically charged gaseous species and essentially electrically neutral but excited gas species. In this context the term "reaction" is utilized to mean one of the following:

        A) formation of a compound on a substrate as

A-37593/HCH/LCB/1
3/30/82

a thin film useful for its optical, chemical, mechanical and/or electrical properties;

B) formation of a bond between a deposited film and a substrate in order to obtain strong adhesion of the deposited film on the substrate surface;

C) etching of a substrate surface in order to remove all of a material formed on the surface or a part of the substrate itself or to selectively remove a specific constituent material among one or more such constituents on or in the surface of the substrate.

One example of the type of reaction specified in paragraph A above involves the deposition of compound semiconductor materials on substrates such as glass, plastic or metal. It is well known that, during evaporation of a compound semiconductor material, the material decomposes, partially or completely, into its constituent elements. The results of such a decomposition is that the thin film deposited on the substrate is generally non-stoichiometric and is thus unsuitable for some particular applications. Apparatus and methods have been developed in the prior art for improving the stoichimetry of deposited films such as metal oxide and metal nitride films, and some of these prior art techniques are generally discussed below.

Another example of the use of an activated molecular beam involves the deposition of aluminum onto silicon to produce an electrode for a high intensity rectifier. In this application, it is imperative to reduce, as much as possible, the electrical resistance of the contact interface between the aluminum and silicon.

Exemplary of the use of a chemical reaction of the type in paragraph B above is an application in which a strong bond is required in the deposition of a protecting or finishing film on a metal substrate. For example, cadmium or zinc layers are sometimes deposited on steel in order to improve resistance to corrosion. Also, materials such as chromium or nickel are often deposited on various metallic substrates for ornamental purposes. A prior art reference disclosing this application of the use of an activated molecular beam to accelerate a chemical reaction is as follows:

"Ion Plating", J. Holden, Product Finishing, Sept. 1977

In this same category of reaction, very hard materials are sometimes deposited on various types of substrates in order to improve their resistance to abrasion or wear, for example the deposition of hard films of carbides or nitrides on steel or films of alumina on glass. This application of activated molecular beams for enhancing or accelerating chemical reactions is disclosed in the following reference:

P. Fauchais et al., "State of the Art of Plasma Chemical Synthesis of Homogenous and Heterogenous Products", Pure and Applied Chemistry, Vol. 52, pp. 1669-1705 (Pergamon Press 1980).

Specific applications for the type of reaction set forth in paragraph C above involve the cleaning of a substrate surface before the application of a thin film and the selective etching of deposited thin films and/or unmasked portions of a substrate itself during the process of manufacturing integrated circuits. References dealing with this application of the use of activated molecular beams are the following:

B. Chapman, "Plasma Etching", Glow Discharge Processes, Chapter 7, p. 247, J. Wiley & Sons, New York (1980).

2. J. W. Coburn et al., "Plasma Etching - A Discussion of Mechanism", J. Vac. Sci. Technol., 16 (1979).

In some applications it is desirable to be able to obtain the improvement of enhanced or accelerated chemical reaction with an activated molecular beam but at a relatively low substrate temperature. This is especially important in the formation of coatings on substrates which have a relatively low melting or transformation point. This constraint is particularly acute in applications involving the formation of thin film optical coatings on either rigid or flexible plastic substrates since plastic substrates are particularly sensitive to relatively moderate heating.

In recent developments in the art, improved apparatus and methods for forming high quality optical and optoelectronic coatings have been achieved by utilizing an activated reactive evaporation technique. By activating the residual gas in the vacuum deposition process, a considerable increase in reactivity with decomposition products from the evaporation source is obtained. This generally results in better adhesion of the deposited film to the substrate, a superior microstructure of the deposited film, lower absorption in transparent coatings, higher conductivity in transparent, conductive coatings greater coating hardness, and higher rate of deposition at lower substrate temperatures. The concept of increasing the reactivity of gas in a reactive evaporation process was first proposed by M. Auwarter in 1957. However, practicable apparatus and methods to implement this concept were not introduced until much later. The following prior art references detail various approaches to producing activation of gaseous species in a reactive evaporation process:

1.   "Reactive Evaporation in Ionized Gases", W. Heitmann, Applied Optics, Vol. 10, No. 11, November 1971.

2.   "A Plasma Source for the Production of Thin Oxide Films", M. Hecq and J. Van Cakenberghe, Thin Solid Films, 12 (1972) 453-456.

3.   "Plasma Deposition of Thin Layers on Substrates", J. L. Van Cakenberghe, U. S. Patent 3,801,355, April 2, 1974.

4.   "Device for Plasma Depositing of Thin Layers Onto Substrates", J. Van Cakengerghe, U. S. Patent 3,886,896. June 3, 1975.

5.   "Depot de Couches Minces D'Oxydes Par Evaporation Sous Impact Ionique Dans Une Decharge Induite", M. Hecq et J. Van Cakenberghe, Thin Solid Films, 33 (1976) 65-87.

6.   "Apparatus for Depositing Thin Coats by Vaporization Under the Simultaneous Action of an Ionized Gas", Erich Zollinger, U. S. Patent 3,980,044, September 14, 1976.

7.   "Preparation of $In_2O_3$ Films by a Novel Activated Reactive Evaporation Technique", P. Nath and R. F. Bunshah, Thin Solid Films, 69 (1980) 68-68.

A-37593/HCH/LCB/5
3/30/82

8.    "Activated Reactive Evaporation of $TiO_2$ Layers and Their Absorption Indices", H. Kuster and J. Ebert, Thin Solid Films, 70 (1980) 43-47.

Another prior art reference which utilizes reactive evaporation techniques is the copending and commonly assigned patent application of H. Gurev entitled "Method and Apparatus for Forming Thin Film Oxide Layers Using Reactive Evaporation Techniques", Serial Number 194,689, filed October 6, 1980 (now abandoned in favor of continuation-in-part application Serial No. 260,047, filed May 4, 1981).  The plasma activation sources disclosed in the Van Cakenberghe references and in the copending Gurev application all require radio frequency energy which is expensive to generate and tends to create radio frequency interference with other electronic instrumentation utilized in a deposition process unless carefully shielded.  The activated gas plasma generators disclosed in the Heitmann, Zollinger, and Kuster et al. references utilize fairly high DC voltages to generate the ions directly.  Also, these approaches are limited to fairly short distances between the source and the substrate for effective reactive evaporation.  This limits the size of the substrate which can be coated in a uniform manner. Moreover, high DC voltages require a relatively expensive power supply to generate them, the voltages tend to be hazardous, and source design must be carefully done to prevent arcing.

Nath et al. teach an approach to enhancing the reactivity of indium and tin vapor species with oxygen reaction gas by utilizing a dense plasma generated by employing a thoriated tungsten emitter and a low voltage anode assembly, with magnetic field coils utilized to confine the plasma to a volume adjacent the substrate. Since this approach involves a filament burning in a residual gas containing oxygen, the resultant rapid oxidation of the filament reduces the effective life of the filament and requires frequent replacement. In addition, in this prior art technique, the substrate temperature is maintained at a relatively high value of around 350 degrees Centigrade to achieve good optical quality in the deposited indium-tinoxide (ITO) film. This substrate temperature is incompatible with substrate temperatures achievable in high rate coating apparatus disclosed in Small U.S. patent 4,015,558. In addition, the substrate temperature utilized by Nath et al. is incompatible with depositing an ITO film on a plastic substrates in either a rigid or flexible film form, since most plastics are incapable of withstanding temperatures above about 100-125 degrees Centigrade even for a short term, low stress exposure.

It is a common prior art practice to use electron guns to generate high velocity electron beams to heat source material in a crucible for melting or vaporization. Depending on the application and the temperature which must be achieved in the crucible, electron guns may use accelerating voltages in the range of 3 to 10 kilovolts with overall power consumption in the range of 2 to 10 kilowatts. Power supplies for such electron gun sources are quite expensive. Furthermore, electron guns sources produce substantial stray electrons which may accumulate on dilectric substrates typically utilized for optical and optoelectronic thin film coatings and interfere with formation of thin films of the requisite quality.

Some reactive evaporation systems use simultaneous activation of gas molecules in a source chamber and evaporation of source material such as silicon oxide from the walls of the source chamber due to the heating of the chamber interior. These systems are limited to a few evaporation source materials and, as discussed above, require the use of high power RF systems. Other reactive evaporation systems require the use of separate apparatus for activating gas molecules and for evaporation of source material with the attendant cumulative expense of the separate pieces of equipment and the cumulative power consumption of both.

Accordingly, it is an object of this invention to provide an improved method and apparatus for producing activated molecular beams.

It is another object of this invention to provide an improved method and apparatus for producing an activated molecular beam which may be utilized to heat target materials to which the beam is directed.

It is another object of this invention to provide an improved method and apparatus for generating an activated molecular beam which may be used simultaneously to evaporate source material and to enhance the reaction of evaporated molecular species with activated plasma species.

More specifically, it is an object of this invention to provide an improved method and apparatus for producing an activiated molecular beam which may be utilized to accelerate chemical reactions in a vacuum chamber environment.

It is a specific object of this invention to provide a method and apparatus for production of activated molecular beams capable of enhancing chemical reactions at low substrate temperatures.

In accordance with one aspect of this invention the above-identified objects are achieved in a method for producing an activated gas plasma in an evacuated first chamber. The method involves creating an activated gas plasma in a substantially closed source chamber adjacent the first chamber at a gas pressure substantially greater than that of the first chamber. The activated gas plasma is then communicated into the first chamber in a high velocity stream and an electric potential is supplied to a region in the first chamber sufficient to produce a continuous gas discharge in the activated gas plasma therein. One version of the method of this invention further includes the step of introducing a second gas into the working chamber to be activated in the continuous gas discharge.

As applied to the formation of a thin film coating on a substrate, one version of the method of this invention further includes the steps of disposing a substrate in the working chamber in the vicinity of the continuous gas discharge within the activated gas plasma. An evaporation source containing a selected material is disposed within the working chamber and the selected material is evaporated onto a surface of the substrate from the evaporation source. The evaporated material thereby reacts with at least one constituent of the activated gas plasma to at least partially alter the physical or chemical characteristics of the thin film formed on the substrate.

A-37593/HCH/LCB/9
3/30/82

As applied to an environment in which the gas plasma is utilized for etching, the method further includes steps of disposing a substrate in the working chamber in the vicinity of the continuous gas discharge and etching a surface constituent of the substrate with at least one species of the activated gas plasma in the continuous gas discharge.

In another version of the invention, a longitudinal magnetic field is created throughout a region of substantial length to confine the high velocity plasma stream exiting the source chamber to a narrow plasma beam communicated into the first chamber. An electrical potential difference is created across a region of the confined magnetic field to produce a sustained gas discharge within the confined plasma beam.

This version of the method of this invention may further include the step of selectively configuring the plasma beam entering the first chamber into a beam of prearranged geometry and direction to impinge upon a selected target within the first chamber. The method of this invention may further include the step of communicating a second gas into the plasma stream within the longitudinal magnetic field to be activated in the gas discharge region. A volume of material to be heated may be disposed within the first chamber and the method of this invention may further include creating a directing magnetic field within the first chamber to direct the plasma beam onto the volume of material. The plasma beam may alternatively be directed to impinge upon substrates disposed within the first chamber for purposes of cleaning or etching.

A-37593/HCH/LCB/10
3/30/82

The method of this invention may be utilized to evaporate thin films onto selective substrates. In such case the method additionally includes the steps of disposing within the first chamber an evaporation source material and disposing one or more substrates within the first chamber in a position opposite the evaporation source material. The plasma beam is directed onto the evaporation source material to evaporate the material onto the substrates. This aspect of the method may be adapted for reactive deposition of a metal oxide evaporation source material by utilizing the step of communicating oxygen into the plasma stream within the longitudinal magnetic field to be activated in the gas discharge region.

In accordance with another aspect of this invention the above-stated objects are achieved in apparatus which includes a substantially closed working chamber and means for evacuating the working chamber to a low pressure. A substantially closed source chamber is mounted adjacent one wall of the working chamber and has a small aperture nozzle extending through the wall to communicate gas therebetween. Means is provided for supplying a selected gas to the source chamber at a pressure substantially greater than the pressure in the working chamber to produce a high velocity stream of the gas entering the working chamber through the nozzle. Means are provided for activating the selected gas within the source chamber before exiting through the nozzle so that the high velocity stream comprises activated gas molecules and anode means are disposed within the working chamber in the path of the stream of activated gas molecules for producing a continuous gas discharge in the activated gas plasma. In one embodiment the invention further comprises a means for supplying a preselected second gas to the working chamber to be activated in the continuous gas discharge therein.

The apparatus may further include a substrate holder means for holding a substrate in the working chamber in the vicinity of the continuous gas discharge and an evaporation source disposed within the working chamber for evaporating a preselected material onto a surface of the substrate.

Another version of apparatus in accordance with this invention features the combination of a substantially closed working chamber, an elongated plasma confinement chamber disposed adjacent the working chamber with a rear gas outlet end communicating with the interior of the working chamber and a front gas inlet end, and a substantially closed source chamber mounted adjacent the gas inlet end of the plasma confinement chamber and having a small aperture nozzle in a rear wall thereof to communicate gas from the source chamber to the plasma confinement chamber. Means are provided for evacuating the interior of the working chamber to a low pressure. Means are also provided for supplying a selected gas to the source chamber at a pressure substantially greater than the pressure within the interior of the working chamber to produce a high velocity stream of the gas through the nozzle. Means are also provided within the source chamber for at least partially activating the molecules of the selected gas within the source chamber before exiting through the nozzle. Means are also provided for creating an electrical potential difference across a region of the plasma confinement chamber to produce a sustained gas discharge within the high velocity stream

A-37593/HCH/LCB/12
3/30/82

of gas exiting the source chamber. Finally, means are provided for creating a longitudinal magnetic field within the plasma confinement chamber to confine activated molecular species of the high velocity gas stream to a narrow high velocity plasma beam.

The apparatus of this invention may further comprise a means for supplying a selected second gas to the plasma confinement chamber near the inlet end so that molecules of the second gas are activated in the sustained gas discharge within the plasma confinement chamber. A preferred embodiment of the apparatus of this invention further includes means for generating within the working chamber a directing magnetic field to convert the narrow plasma beam exiting the confinement chamber to a plasma beam of prearranged geometry and direction.

The apparatus of this invention may further include specific elements for adapting the apparatus for vacuum evaporation of a preselected material including target material to be evaporated in the presence of activated molecules of a second gas for enhancing the electrical or optoelectronic characteristics of the deposited thin film.

This invention takes advantage of two principles concerning the production and utilization of activated species in gases. The first general principle is that the production yield of activated species varies directly with the gas pressure in the activation region. Second, the lifetime of activated species is generally an inverse function of the gas pressure. The method and apparatus of this invention makes advantageous use of these principles by producing the activated species in a region of high pressure and then
using fluid dynamic effects to rapidly bring the
activated species into a region of lower pressure where
the lifetime thereof is much longer. It is thus
possible to produce an overall higher yield of
activated species in the lower pressure region or
working chamber. In particular, this invention
advantageously uses an arrangement for producing
activated species on the upstream side of a small
apertured nozzle located in the wall between the source
chamber and the working chamber but at a point where
the pressure is still fairly high and the velocity of
the gas is relatively low. The activated species then
rapidly enter the lower pressure, higher velocity
region of the nozzle to be injected as a high velocity
stream into the working chamber.

Thus in accordance with this invention both good
production yield and high lifetime of activated species
for utilization in the working chamber is achieved.
Moreover, because of the high activation yield and
increased lifetime of activated species, it is possible
to initiate and sustain a gas discharge within the
activated species in the working chamber with an
electrical potential difference much smaller than would
otherwise be required.

More importantly for some applications, this invention
advantageously utilizes activation of a noble gas in
the source chamber with a heated filament and DC anode
arrangement together with a secondary activation of
oxygen directly introduced into the working chamber in
the gas discharge area produced by a second anode in
the working chamber. The use of noble gas in the
source chamber gives the advantage of a long lifetime

A-37593/HCH/LCB/14
3/30/82

of the filament since the filament is not burning in a residual oxygen atmosphere. Furthermore, the high yield of activated species within the working chamber permits, in one version of the invention, a relatively low voltage DC anode to be utilized in the working chamber near a substrate to provide high activation of the oxygen gas molecules in the region of the substrate. This results in a high yield of activated oxygen species for reacting with evaporated metal or metal oxide species arriving from an evaporation source within the working chamber. The overall advantageous result is an enhancement of the reaction at the substrate surface so that higher deposition rates can be achieved at lower substrate temperatures while maintaining advantageous physical characteristics of the thin film deposited on the substrate.

The second general version of this invention has the basic advantages inherent in the principles of the apparatus and method of the first version with further specific enhancements of methodology and apparatus which provide for creation of a highly activated and concentrated gas plasma beam which has both high kinetic energy and high activation energy. As a result the activated molecular beam may be used for heating target materials to the high temperatures required for melting and/or evaporation. Moreover, the plasma beam generated in accordance with the method and apparatus of this invention is sufficiently concentrated into a narrow beam and has a sufficiently high content of ionized molecular species that the beam can be selectively directed by way of magnetic field generating means such as magnetic lenses, congentrators and the like to impinge on a selected target region within the working chamber. Accordingly, the

A-37593/HCH/LCB/15
3/30/82

concentrated plasma beam may be alternatively directed toward or focused onto substrate materials disposed within the vacuum chamber or directed toward or focused on evaporation source material within a crucible or on other work pieces within the chamber. A variety of work functions may thus be accomplished by the directed plasma beam.

The principles of the method and apparatus of the second general version of this invention provide special advantages when applied to reactive evaporation of metal oxide evaporation source materials to produce thin films of desired optical or optoelectronic quality on substrates disposed within the vacuum chamber. Use of this second version of the invention eliminates the need for a separate electron gun evaporation source arrangement and an activated gas plasma source arrangement. The plasma beam generated in accordance with this invention may be utilized to evaporate the source material and, with the introduction of oxygen into the plasma beam within the plasma confinement region, a high population of activated oxygen species is provided throughout the working chamber so that high quality thin films with good optical or optoelectronic performance characteristics are readily formed.

The method and apparatus of this invention has the further advantage that the ionized molecular species within the working chamber appear to be balanced with free electrons within the chamber so that build-up of charges on dielectric substrates surfaces does not occur. Furthermore, the power consumption requirements of the plasma beam source provided in accordance with the method and apparatus of this invention is substantially less than required for operating an electron gun evaporation source and utilizes voltages in the 100-300 volt range which are easier and substantially less expensive to generate.

The apparatus and method of this invention may find useful application in a variety of technologies in addition to the vacuum evaporation of thin film coatings. For example, the invention may be applied to the melting or soldering, under vacuum conditions, of refractory metals like zirconium, tungsten, molybdenum and tantalum. The invention is also useful for melting, soldering or evaporation of electrically insulating materials, such as oxides, borides, nitrides and carbides of metals such as zirconium, hafnium and tungsten. The invention may also be used as a source of charged particles, i.e. ions and electrons, for various applications such as electron beam heating, reactive ion etching, ion plating, and nuclear fusion experiments. Additional applications may involve spectroscopic analysis, isotopic separations and testing of materials and equipment for use in space applications.

Other objects, features and advantages of this invention will be apparent from a consideration of the following detailed description in conjunction with the accompanying drawings.

Fig. 1 is a schematic diagram of apparatus in accordance with one version of this invention useful in carrying out the method of this invention.

Figs. 2-4 are schematic diagrams of various alternative embodiments of apparatus in accordance with this invention useful in carrying out the method of this invention.

Fig. 5 is a partly schematic, sectioned elevational view of a preferred embodiment of one version of apparatus in accordance with this invention and useful in carrying out the method of this invention.

Fig. 6 is a partly schematic, sectioned elevational view of one embodiment of a second version of apparatus in accordance with this invention and which may be used in carrying out the method of this invention.

Fig. 7 is a partial section view of the embodiment of Fig. 6, illustrating an alternative operational feature of the invention.

Fig. 8 is a partial schematic view of an alternative embodiment of apparatus in accordance with this invention which may also be used in carrying out the method of this invention.

Fig. 9 is a partly sectioned elevational view of a plasma source arrangement in accordance with this invention.

Fig. 10 is an end view of the filament holder portion of the plasma source arrangement of Fig. 9.

Fig. 11 is a schematic view of apparatus for low pressure welding using the principles of this invention.

Fig. 12 is a schematic view of apparatus for low pressure plasma induced sputtering using the principles of this invention.

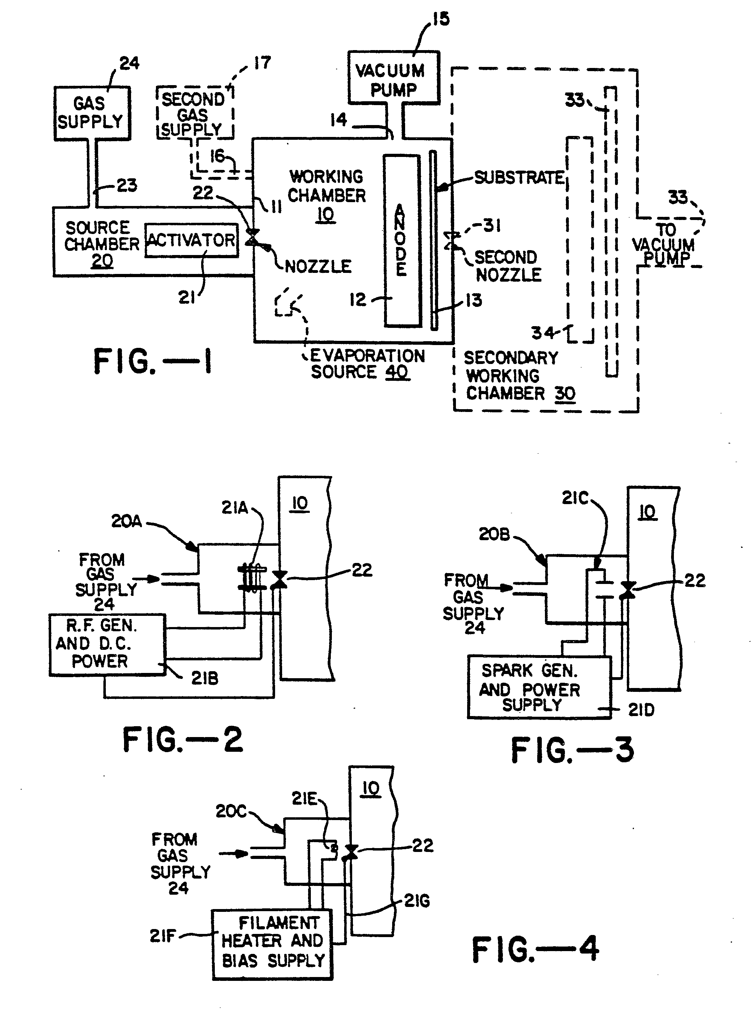

Referring now to Fig. 1, the general components of a first version of apparatus in accordance with this invention and the general aspects of the methodology of this invention will be discussed. The apparatus of this first version generally includes a substantially closed working chamber 10, also sometimes referred to as a vacuum deposition chamber when the invention is applied to the vacuum deposition of thin films. A vacuum pump 15 communicates with working chamber 10 through a port 14 and serves as means for evacuating working chamber 10 to a low pressure. A substantially closed source chamber 20 is mounted adjacent the wall 11 of working chamber 10 and has a small-aperture nozzle 22 extending through wall 11 to communicate gas between the source chamber 20 and the working chamber 10.

A gas supply 24 communicates with source chamber 20 through a conduit 23 and serves as means for supplying a selected gas to source chamber 20 at a pressure substantially greater than the pressure in the working chamber 10. The pressure differential between the source chamber 20 and the working chamber 10 produces a high velocity stream of the gas entering the working chamber 10 through nozzle 22. Within source chamber 20 is located an activator means 21 which activates the gas from gas supply 24 before it exits through nozzle 22 so that the high velocity stream entering working chamber 10 comprises an activated beam of gas molecules. Within the working chamber 10 an anode 12 is provided which together with biasing means (not shown) which may be located outside working chamber 10, serves as anode means for producing a continuous gas discharge in the activated gas plasma communicated into working chamber 10 through nozzle 22. This results in a sustained activated gas plasma in the region of the anode means 12 which, depending on the gas species employed may be utilized for one of the applications discussed above.

Generally, the apparatus shown in Fig. 1 is also adapted to carry out the method of this invention for producing an activated gas plasma in an evacuated working chamber 10 and involves creating an activated gas plasma in a substantially closed source chamber 20 adjacent working chamber 10 at a gas pressure substantially greater than that of working chamber 10. This is accomplished by supplying a preselected gas to source chamber 20 at a rate sufficient to maintain a higher pressure therein and creating an activated gas plasma using activator 21. The second step of the method is communicating the activated gas plasma into the working chamber in a high velocity stream. This step is carried out utilizing the nozzle 22 and the pressure differential between the two chambers. The third general step in the method is supplying an electric potential to a region in the working chamber 10 to produce a continuous gas discharge in the activated gas plasma. This is carried out using the anode means 12 to produce a continuous gas discharge in the region surrounding the anode means.

In one embodiment of the apparatus and method of this invention a second gas supply 17 is communicated through conduit 16 into working chamber 10. This second gas is communicated to working chamber 10 at a flow rate which permit the maintenance of a low

A-37593/HCH/LCB/20
3/30/82

pressure in working chamber 10. The gaseous species from the second gas supply are activated within the continuous gas discharge region created around anode 12 and are thus available for use in enhancing chemical reactions at or on the surface of substrate 13. The invention is not limited to use of a single second gas supply or to the use of a single source chamber. Instead, additional gas species may be communicated to the working chamber 10 either directly or through one or more additional source chambers containing activator means therein. In other words, to increase the density of activated species within working chamber 10 additional activation sources supplying high velocity streams of activated gas molecules of either the same or different species may be communicated into working chamber 10.

If the invention is applied to the formation of a thin film layer on substrate 13 using a reactive evaporation technique, then an evaporation source 40 will be provided within working chamber 10, with evaporation source 40 including appropriate heating or other source material evaporation means to produce a beam of source material vapors communicated to the surface of substrate 13 through the gas discharge region produced by anode 12.

In accordance with this invention it is also possible to utilize a series of working chambers at different pressures to produce a serial arrangement of activation sources. As shown in dashed lines in Fig. 1, a secondary working chamber 30 may be disposed adjacent the primary working chamber 10 with a second nozzle 31 in the wall between the chambers. In such an embodiment the substrate 13 would generally be

A-37593/HCH/LCB/21
3/30/82

eliminated from working chamber 10 and working chamber 10 would become in effect a source chamber for working chamber 30. In this fashion activated molecular beams for a large working chamber may be produced in a multi-stage source arrangement. The working chamber 10 effectively operates as a source chamber for secondary working chamber 30 and may be supplied with its own gas supply of either the same or different gas species to increase the density of activated gas species to be communicated to secondary working chamber 30 through nozzle 31. Secondary working chamber 30 will typically have a substrate 33 positioned therein and may also include an anode 34 to produce a continuous gas discharge within secondary working chamber 30.

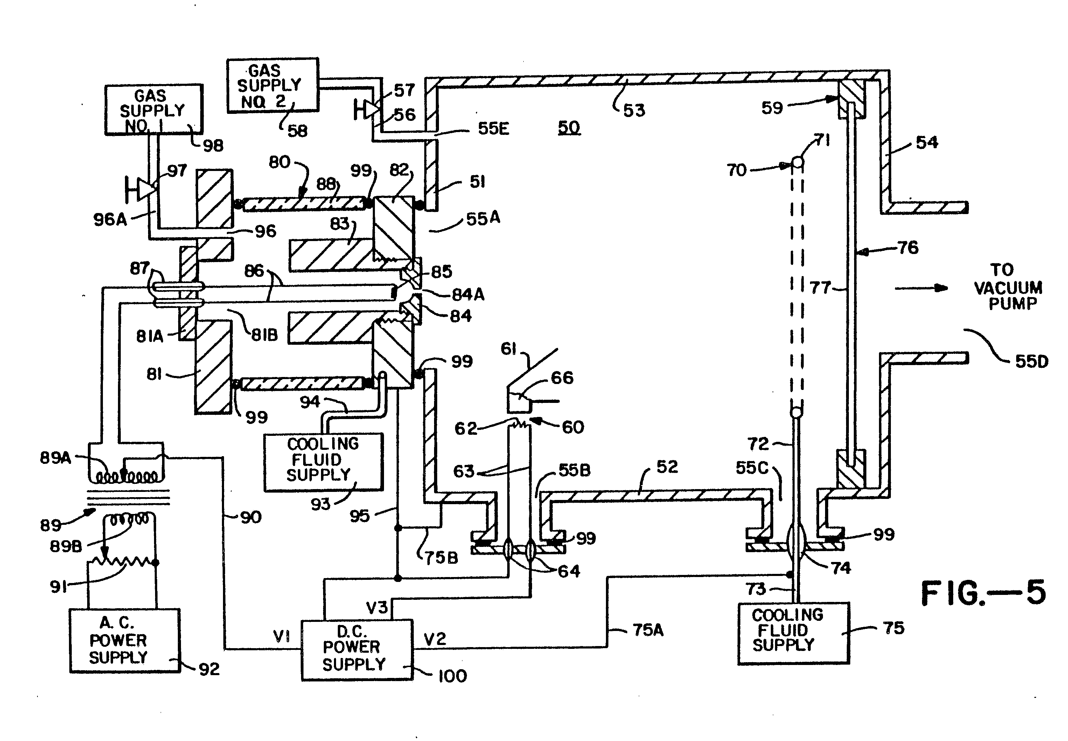

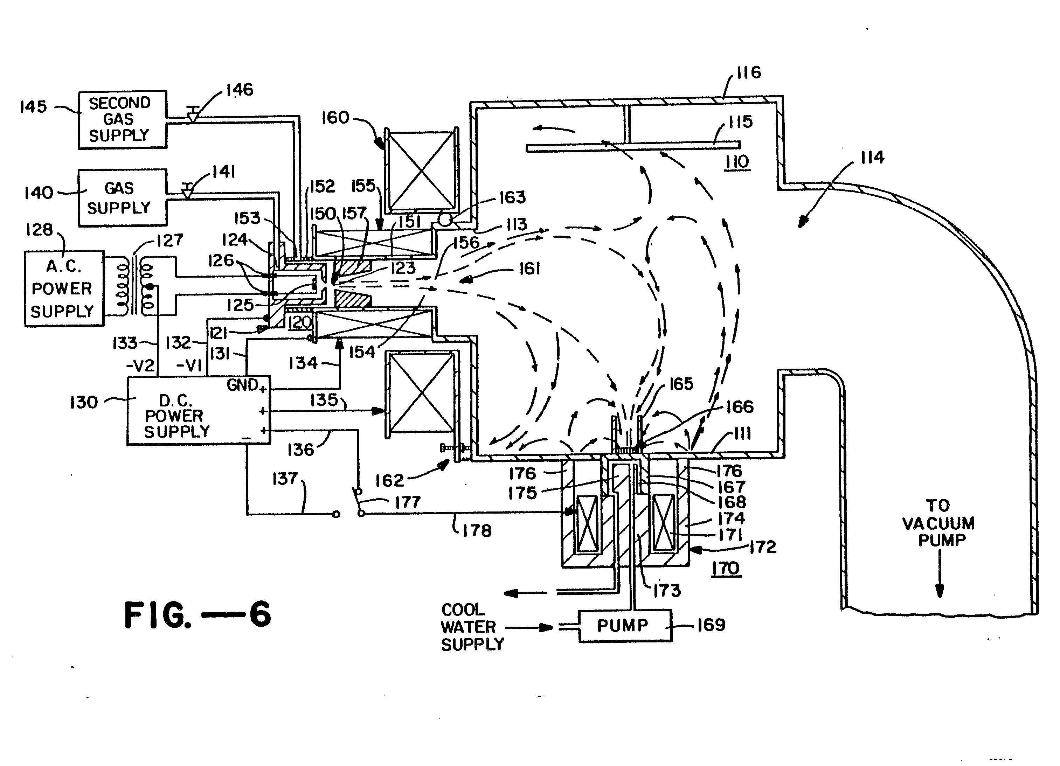

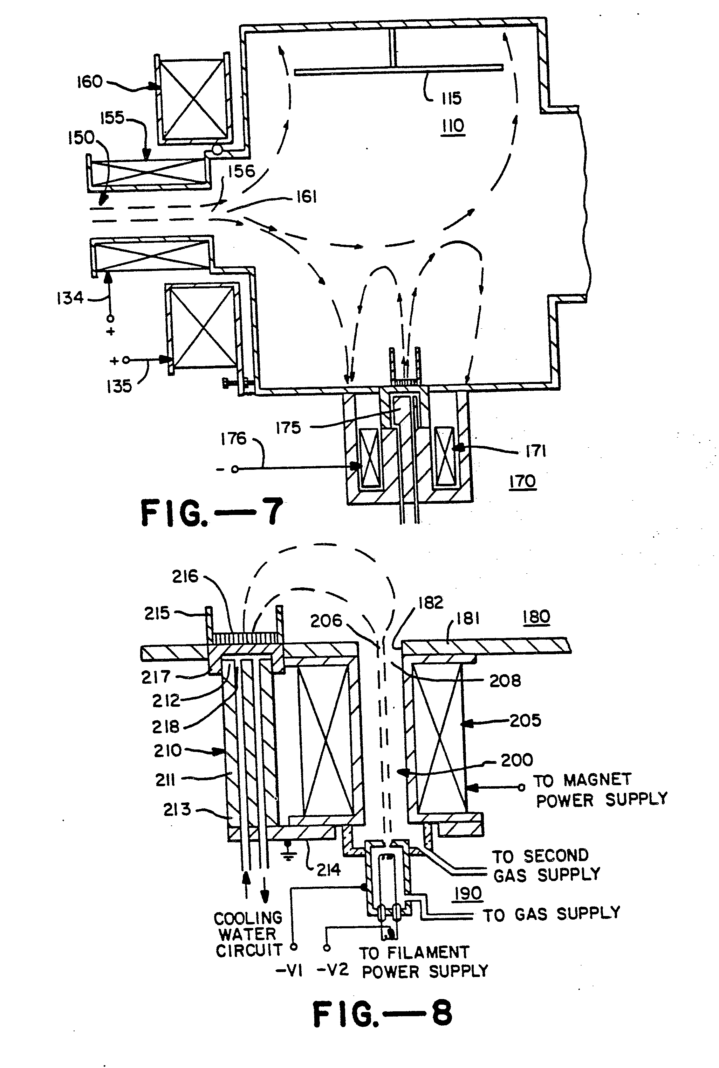

Figs. 2-4 illustrate various embodiments of an activator means which utilize different arrangements for initiating the discharge within the activator means, but all involving the sustaining of the gas discharge within source chamber 20 with a DC bias arrangement. In Fig. 2 the initiation of the discharge is created by a radio frequency field within a small coil 21A with the radio frequency and direct current power supplied from a source 21B. In Fig. 3 the initiation of the gas discharge within source chamber 20B is provided by a spark electrode arrangement 21C fed by a spark generator and power supply 21D. In Fig. 4 the initiation of the discharge is provided by a filament 21E which is heated from a filament heater and bias supply 21F. In each of these arrangements the gas discharge is sustained by a DC potential applied between the anode arrangement which includes nozzle 22 and the discharge initiating means which serves as a cathode. Generally, the anode including the nozzle 22 will have a ground potential supplied thereto and the discharge sustaining DC potential will be applied to the discharge initiating means. In each instance the discharge initiating means is located closely adjacent the nozzle 22 so that activation of the gaseous species will occur in the immediate vicinity of the nozzle but at a point where substantial gas pressure and low fluid velocity exists.

Fig. 5 depicts an exemplary embodiment of this invention as applied to a method and apparatus for forming a thin film in a reactive evaporation process. In this case the working chamber 50 is a vacuum deposition chamber which includes an evaporation source arrangement 60. Substrate holder 59 positions a substrate 76 at one end of chamber 50. In the vicinity of substrate 76 at one end of chamber 50. In the vicinity of substrate 76 is an anode arrangement 70. A port 55D in wall 54 leads to a vacuum pump (not shown) for evaculating the interior of deposition chamber 50. An inlet port 55E in wall 51 is provided for communicating a selected reactant gas from a gas supply 58 through a conduit 56 regulated by a needle valve arrangement 57.

As shown in Fig. 5 the evaporation source arrangement 60 is a resistance-heated type which includes a crucible 61, a resistance heater 62 for the crucible 61 and electrical leads 63 for the resistance means 62 which are communicated through insulated lead through arrangements 64 in the end wall of port 55B. The electric supply leads 63 are communicated to a DC power supply 100 to provide electric current to the resistance heating means 62. This is a conventional resistance heating evaporation source arrangement and other types of conventional evaporation source arrangements such as electron beam evaporation units may also be employed with this invention.

The particular anode arrangement 70 utilized in the embodiment shown in Fig. 5 consists of a water-cooled copper coil 71 with a conduit 72 communicating through a port 55C in chamber 50 to a cooling fluid supply 75. An insulated feed through 74 is provided in the end wall of port 55C for electrically isolating the conduit 72 from the walls of the deposition chamber. An electric lead 75A is connected to the conduit 72 by way of an appropriate connector 73 which may involve a clamp or other means to supply a DC potential V2 from DC power supply 100 to the surface of anode arrangement 70.

Source chamber 80 comprises a pair of disks 81 and 82 separated by a hollow cylindrical glass tube 88. Gaskets 99 are provided for sealing the ends of glass tube 88 against the mating surfaces of the disks 81 and 82 and also for sealing the surface of disk 82 against the wall 51 of deposition chamber 50. In this fashion the disk 82 covers the port 55A in deposition chamber 50. Any suitable clamping means (not shown) may be employed to mount the source chamber 80 to the wall 51 of chamber 50 and to clamp the disks and glass cylinder together.

Disk 82 is formed of a preselected conductive metal such as aluminum. Disk 82 has a centrally located aperture into which one end of a cylinder 83 is threaded. At the front end of cylinder 83A, a nozzle 84 having a small aperture 84A therein is threaded. Disk 82, cylinder 83, and nozzle 84 serve as an anode which is connected by way of a lead 95 to DC power supply 100. Typically this anode will be connected to ground potential along with the walls of deposition chamber 50 which are connected to the same point on DC power supply 100 through line 75B.

The front disk 81 also has a central aperture 81B formed therein which is covered by a second disk 81A. Appropriate sealing means may be employed for disk 81A to preclude gas leakage. A small port 96 is provided in disk 81 and communicates via a conduit 96A to a first gas supply 98. A needle valve 97 may be provided for regulating the flow of gas from supply 98 into the interior of source chamber 80.

A coiled filament 85 is positioned within cylinder 83 closely adjacent the nozzle 84. Filament 85 may be supported within cylinder 83 using any conventional support arrangement using electrically insulating material. Conductive leads 86 extend through insulating lead through devices 87 in the wall 81Ato connect filament to a secondary winding 89A on transformer 89. Primary winding 89B of transformer 89 is connected to an AC power supply 92 with a potentiometer 91 controlling the current through the primary winding 89B. In this fashion the current from AC power supply 92 is transformer-coupled into the filament 85 and will produce a heating of the filament. A center tap on secondary winding 89A is connected by way of a lead 90 to DC power supply 100 to place a DC potential V1 on the filament 85. Filament 85 thus serves as a cathode of a gas discharge activation source arrangement.

Anode 82 has a cooling coil 94 extending therethrough and communicating with a cooling fluid supply 93 to

A-37593/HCH/LCB/25
3/30/82

maintain anode 82 at a convenient operating temperature.

An exemplary embodiment of the invention was constructed and utilized to deposit a transparent coating of indium oxide on a substrate comprising a flexible plastic sheet (e.g. mylar). In this embodiment source 80 utilized two aluminum disks twenty centimeters in diameter and two centimeters thick for the end walls 81 and 82. Disk 82 was provided with a threaded central aperture six centimeters in diameter into which a one centimeter thick hollow cylinder 83 of aluminum was threaded. One end of cylinder 83 was threaded and received a nozzle arrangement 84 having an aperture 84A with a diameter of two millimeters. Filament 85 was constructed from tungsten wire having a 0.5 millimeter diameter and being coiled on a mandrel of two millimeter diameter to make a twenty-turn coil. Filament 85 was positioned five millimeters from aperture 84A in nozzle 84.

Argon gas from gas supply 98 was introduced into source 80 through needle valve 97 to produce a pressure of one Torr in source chamber 80. A DC potential V1 of 100 volts was applied to filament 85 with a resistance of ten Ohms to limit the current. Filament 85 was heated by a current from AC power supply 92 through transformer 89 until a DC current of six Amps was observed to flow between the filament/cathode 85 and anode 82/84.

The deposition chamber 50 was constructed with a diameter of 60 centimeters and a length of 100 centimeters. Chamber 50 was connected to a diffusion pump having a speed of 5000 l/s at $10^{-4}$ Torr. With the

source chamber 80 connected, the pressure in the deposition chamber 50 was about $0.5 \times 10^{-5}$ Torr.

Oxygen gas from gas supply 58 was introduced through needle valve 57 into the deposition chamber until the pressure inside attained a value of about $10^{-4}$ Torr. A crucible 61 containing indium was positioned within deposition chamber 50 at a distance 25 centimeters from the nozzle 84. Mylar substrates 76 were placed at about 50 centimeters from the crucible 61, putting them about 75 centimeters from nozzle 84. The mylar substrate was about 20 x 27 centimeters.

The second anode arrangement 70 was placed in front of the mylar substrate 76 with a spacing of about 10 centimeters. This anode was constructed of a coil of copper tubing with a coil diameter of about 40 centimeters. A DC potential V2 of about 200 volts was supplied via line 75A to anode 70. With the source chamber 80 operating, a current of about fifteen Amps was observed in the circuit involving second anode 70.

The crucible 61 of indium 66 was heated until a quartz thickness monitor (not shown) located within deposition chamber 50 registered a thin film growth rate of about 200 Angstroms per minute. Indium was deposited for about ten minutes to produce a film thickness of about 2000 Angstroms. Specimens prepared were tested and showed a transmissivity for white light greater than ninety percent. During the deposition process the temperature of the substrate rose to about 50 degrees Centigrade. In other experiments, indium-tin source material was used and an indium-tin oxide coating was produced.

While the above-described example of one version of apparatus in accordance with this invention and the utilization of the method in accordance with this invention employed the specific parameters and apparatus constructions set forth, it should be understood that numerous alternative designs and methodologies could be employed without departing from the general principles of this invention. As previously indicated, the invention may be utilized in applications other than the evaporation of coatings onto a substrate in a reactive evaporation mode. In addition, while there are a number of parameters which are important to the achievement of the beneficial results of this invention, the parameters employed in a particular embodiment for a particular purpose will generally be specifically tailored to that application. In particular, it should be noted that the invention is not limited to any particular size of deposition chamber or other working chamber. In order to provide sufficent density of activated gas species within a large deposition chamber, two or more sources may be employed. In some embodiments it may be preferable to have the reacting gas directly activated in the source rather than feeding the reacting gas species directly into the deposition chamber. However, this approach generally should not be taken where the lifetime of the filament will be affected by the corrosive or other deleterious effects of the gas supplied thereto.

In general, the diameter and shape of the aperture 84A in nozzle arrangement 84 will vary with a number of parameters such as the nature of the gas in the source chamber, the power of the vacuum pump associated with the working chamber, the working pressure in the source chamber, and the thickness and other characteristics of the nozzle. Another variable parameter is the distance between the filament 85 or other discharge initiating means and the nozzle 84. Generally this distance varies with the working pressure in the source chamber so that the position of the filament/cathode 85 will be located at a region where the pressure of the source gas species is relatively high to produce high yield of activated gas species but is also sufficiently close to the aperture 84A in nozzle 84 that the activated gas molecules will rapidly by injected into working chamber 50. The DC potentials applied to the filament/cathode 85 and to the second anode 70 will generally vary as a function of the working pressures in the associated chambers. However, the potential required to be applied to the anode 70 is much lower than would otherwise be required to sustain a gas discharge if activated gas species from the source were not present within that chamber. Instead of supplying a positive DC potential to anode arrangement 70, it is also possible to utilize the same arrangement as a cathode and supply a negative potential thereto.

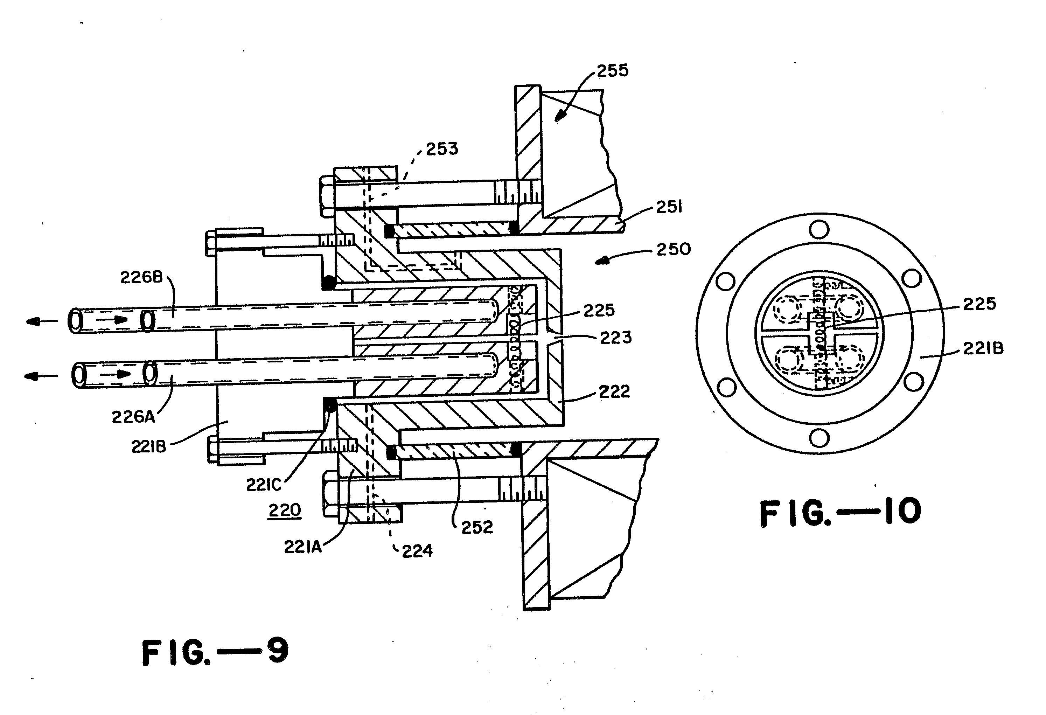

Referring now to Fig. 6, general aspects of apparatus and method in accordance with a second general version of this invention will be discussed. The apparatus generally includes a substantially closed working chamber 110 which will also be referred to as a vacuum deposition chamber in discussing the application of the invention to vacuum deposition of thin films. A port 114 is formed in one wall of working chamber 110 and communicates with a vacuum pump (not shown) for evacuating the interior of working chamber 110 to a low pressure. A plasma source arrangement 120 and a plasma confinement arrangement 150 communicate with the interior of working chamber 110 through a port 113 in sidewall 112.

Plasma source arrangement 120 includes a substantially closed source chamber 121 with a nozzle 123 formed in a rear wall 122 thereof. A filament 125 mounted within chamber 121 is electrically connected to transformer 127 by leads extending through feed-throughs 126 in the back wall of source chamber 121. AC power supply 128 is connected to transformer 127 to supply power for heating the filament 125. A gas inlet port 124 communicates with a gas supply 140 through a metering valve 141.

Plasma confinement arrangement 150 comprises a hollow cylindrical chamber section 151 formed from an electrically conductive, non-magnetic material such as aluminum and a front cylindrical chamber section 152 formed of electrically insulating material and extending between the walls of source chamber 121 and the electrically conducting wall section 151. A gas entry port 153 communicates with a second gas supply 145 through a metering valve 146. An elongated, electromagnet coil 155 surrounds the exterior of confinement chamber section 151.

A second electromagnet coil 160 is disposed around the inlet port 113 of working chamber 110. In the embodiment of Fig. 6, working chamber 110 is set up as a vacuum deposition chamber with a substrate holder 115 schematically shown as positioned adjacent top wall 116. A source crucible 165 is positioned on bottom wall 111 of vacuum chamber 110 to confine a volume of material 166 serving as an evaporation source. Crucible 165 and source material 166 rest on a copper hearth 167 which is cooled by a liquid such as water flowing through a cooling chamber 168. The cooling water is provided by a pump 169 communicating with a cool water source.

A magnetic concentrator arrangement 170 is provided adjacent the bottom wall 111 of chamber 110. Magnetic concentrator arrangment 170 includes an electromagnet coil 171 disposed in a soft iron core structure 172 which includes a cylindrical core section 173 which is substantially solid and a hollow cylindrical pole-piece section 174. The core and pole-piece arrangement 172 forms a first magnetic pole 175 at the top of central core section 173 and a second magnetic pole 176 at the top of the cylindrical pole-pieces 174.

A power supply 130 includes a ground output coupled by way of lead 131 to the hollow cylindrical wall section 151 of plasma confinement chamber 150. A negative DC voltage -V1 is supplied via lead 132 to the walls of plasma source chamber 121. A second negative DC voltage -V2 is communicated via lead 133 to a center tap on the output winding of transformer 127 to apply DC bias to the filament 125. Power supply 130 also supplies positive DC voltages for operating the electromagnet coils 155 and 160 via leads 134 and 135. Alternative positive and negative supply voltages are provided via leads 136 and 137 to a switch 177 which selectively connects one of the two supply potentials via lead 178 to electromagnet coil 171.

The basic principles of operation of the apparatus shown in Fig. 6 are as follows.

An activated gas plasma is created in source arrangement 120 by communicating a gas from gas supply 140 into the interior of source chamber 121 and initiating a gas activating plasma discharge in the vicinity of the nozzle 123 by heating filament 125 and applying a potential difference between filament 125 and the front wall 122 of chamber 121. This potential difference is supplied by power supply 130. The flow rate of the gas from gas supply 140 is maintained at a level such that the pressure within source chamber 121 is substantially greater than the pressure within the evacuated working chamber 110 and correspondingly higher than the pressure within confinement chamber 150. At this higher pressure, the production yield of activated species in the gas from gas supply 140 is relatively high. Furthermore, due to the pressure differential between the interior of source chamber 121 and the interior of working chamber 110, this activated gas plasma will be communicated out of the nozzle 123 into the plasma confinement chamber 150 as a high velocity stream.

The current supplied to electromagnet coil 155 creates a longitudinal magnetic field within the interior of plasma confinement chamber 150 which guides and compresses the high velocity plasma stream communicated through the nozzle 123. A DC potential difference is established between the front wall 122 of source chamber 121 and the wall section 151 of the plasma confinement chamber 150. This potential difference sustains a gas discharge within the high velocity plasma stream exiting the nozzle 123. The narrow plasma beam 156 exiting the outlet end 154 of plasma confinement chamber 150 contains a high concentration of ionized gas molecules and excited gas atoms as well as electrons. The combination of the kinetic energy of the plasma beam and the stored energy within excited states of the atoms and molecules enables the plasma beam 156 to perform a variety of functions within the working chamber 110. In addition, the ionized molecules of the beam may be directed using magnetic directing means such as electromagnet coils 160 and electromagnet concentrator arrangement 170 to direct and/or concentrate the plasma beam onto a particular target structure witbin working chamber 10.

As shown in Fig. 6, magnetic beam directing means in the form of the combination of electromagnet coil 160 and the electromagnet focusing arrangement 170 may be utilized to create within working chamber 110 a magnetic field distribution (shown as dashed lines of force) which bends the narrow plasma beam 156 in the direction of the source crucible 165 and focuses the beam to a narrow region within the crucible. This arrangement is particularly well-suited for utilizing the beam to heat an evaporation source material 166 positioned within crucible 165 to evaporate the material onto one or more substrates on substrate holder 115. The dashed lines shown within the interior of working chamber 110 in Fig. 6 illustrate the distribution of some of the magnetic lines of force which comprise a magnetic field distribution within the chamber when the polarity of voltages applied to coils 160 and 170 is such that the magnetic pole at point 161 due to coil 160 is opposite to the magnetic pole 175 due to coil 170.

This same directing and focusing operation on the plasma beam 156 may be utilized for melting or soldering, under high vacuum conditions, of refractory metals like zirconium, tungsten, molybdenum and tantalum positioned within source crucible 165. If the purpose of the apparatus is simply to melt or to heat-treat various materials, the combined bending and focusing of the beam may be superfluous and the magnetic focusing arrangement 170 could have its central axis aligned with the central axis of plasma confinement chamber 150. Such an arrangement is shown in Fig. 11.

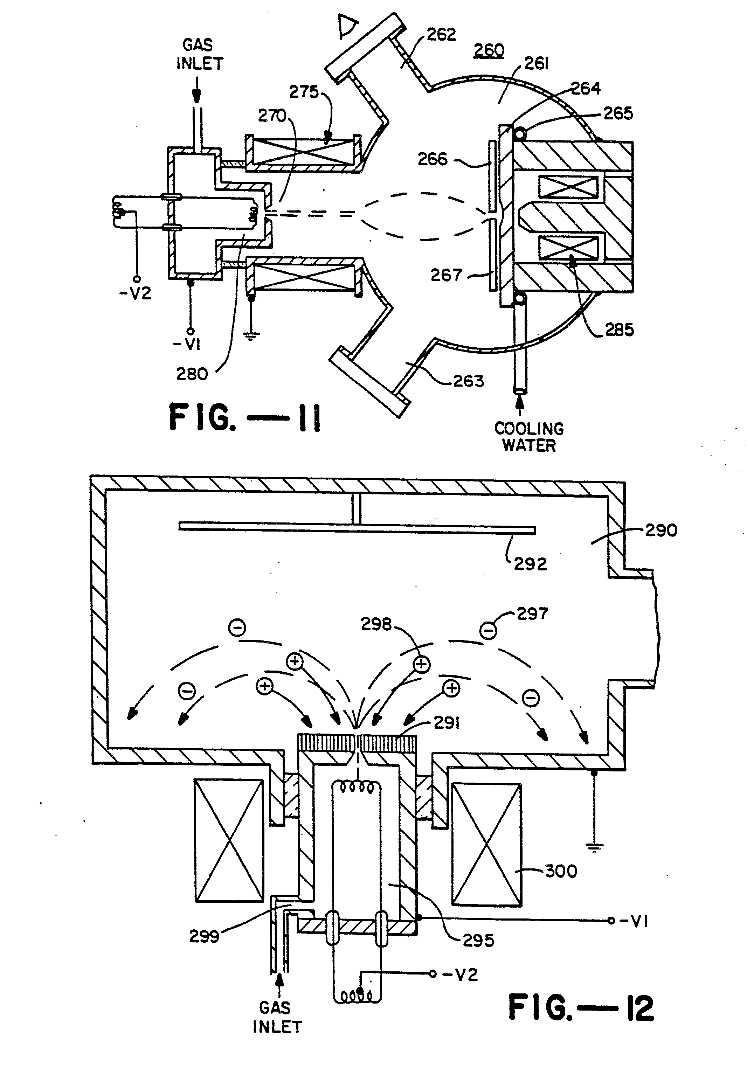

Fig. 7 illustrates that the combination of the electromagnet coil 160 and the magnetic focusing arrangement 170 can also be utilized to configure the plasma beam 156 exiting the plasma confinement chamber 150 into a distributed and upwardly deflected ion beam which may be used, for example, to perform a predeposition cleaning of substrates placed on substrate holder 115. The same approach can be utilized to generate a large diameter ion source for other purposes such as ion etching of semiconductor materials. To achieve the magnetic field distribution shown in Fig. 7, the polarity of the voltage applied to the coil 171 may be reversed utilizing the switching means 177 shown in Fig. 6, so that the magnetic pole at 161 is the same as the magnetic pole at 175.

Fig. 9 illustrates an alternative embodiment in which a plasma source arrangement 190 and a plasma confinement chamber 200 are mounted adjacent to the bottom wall 181 of working chamber 180 with plasma beam 206 directed into working chamber 180 through an inlet port 182. In this embodiment a permanent magnet 210 is disposed with its magnetic pole at 212 opposite to the pole at 208 due to electromagnet coil 205. Permanent magnet 210 is positioned under the source crucible 215 which is resting on the copper hearth 217. A cooling water circuit 218 may be provided through the permanent states of the atoms and molecules enables the plasma beam 156 to perform a variety of functions within the working chamber 110. In addition, the ionized molecules of the beam may be directed using magnetic directing means such as electromagnet coils 160 and electromagnet concentrator arrangement 170 to direct and/or concentrate the plasma beam onto a particular target structure witbin working chamber 10.

As shown in Fig. 6, magnetic beam directing means in the form of the combination of electromagnet coil 160 and the electromagnet focusing arrangement 170 may be utilized to create within working chamber 110 a magnetic field distribution (shown as dashed lines of force) which bends the narrow plasma beam 156 in the direction of the source crucible 165 and focuses the beam to a narrow region within the crucible. This arrangement is particularly well-suited for utilizing the beam to heat an evaporation source material 166 positioned within crucible 165 to evaporate the material onto one or more substrates on substrate holder 115. The dashed lines shown within the interior of working chamber 110 in Fig. 6 illustrate the distribution of some of the magnetic lines of force which comprise a magnetic field distribution within the chamber when the polarity of voltages applied to coils 160 and 170 is such that the magnetic pole at point 161 due to coil 160 is opposite to the magnetic pole 175 due to coil 170.

This same directing and focusing operation on the plasma beam 156 may be utilized for melting or soldering, under high vacuum conditions, of refractory metals like zirconium, tungsten, molybdenum and tantalum positioned within source crucible 165. If the purpose of the apparatus is simply to melt or to heat-treat various materials, the combined bending and focusing of the beam may be superfluous and the magnetic focusing arrangement 170 could have its central axis aligned with the central axis of plasma confinement chamber 150. Such an arrangement is shown in Fig. 11.

Fig. 7 illustrates that the combination of the electromagnet coil 160 and the magnetic focusing arrangement 170 can also be utilized to configure the plasma beam 156 exiting the plasma confinement chamber 150 into a distributed and upwardly deflected ion beam which may be used, for example, to perform a predeposition cleaning of substrates placed on substrate holder 115. The same approach can be utilized to generate a large diameter ion source for other purposes such as ion etching of semiconductor materials. To achieve the magnetic field distribution shown in Fig. 7, the polarity of the voltage applied to the coil 171 may be reversed utilizing the switching means 177 shown in Fig. 6, so that the magnetic pole at 161 is the same as the magnetic pole at 175.

Fig. 9 illustrates an alternative embodiment in which a plasma source arrangement 190 and a plasma confinement chamber 200 are mounted adjacent to the bottom wall 181 of working chamber 180 with plasma beam 206 directed into working chamber 180 through an inlet port 182. In this embodiment a permanent magnet 210 is disposed with its magnetic pole at 212 opposite to the pole at 208 due to electromagnet coil 205. Permanent magnet 210 is positioned under the source crucible 215 which is resting on the copper hearth 217. A cooling water circuit 218 may be provided through the permanent

A-37593/HCH/LCB/34
3/30/82

in the experimental apparatus. The source chamber 220 includes a main source housing 221A and a filament holder housing 221B assembled together with a sealing O-ring 221C as depicted in Fig. 9. The plasma source arrangement 220 may be mounted to the coil bobbin 251 for electromagnet coil 255 utilizing the bolt mounting arrangement depicted in Fig. 9. In this mounting arrangement a cylindrical ring 252 of electrically insulating material together with a pair of sealing rings 252A and 252B may be provided. The front wall 222 of the main chamber housing 221A includes a nozzle 223 having a smallest aperture diameter of 2 mm. The filament 225 is mounted within the filament holder housing 221B utilizing the split holder arrangement depicted in Figs. 9 and 10 with cooling of the individual halves of the split mounting arrangement provided by ciculation of cooling fluid through the separate cooling tubes 226A and 226B.

The primary gas inlet 224 constitutes a channel through the main housing section 221A. The second gas inlet is provided by a channel 253 through the housing 221A which communicates a second gas into the annular space around the housing 221A.

In an actual embodiment of the plasma source arrangement 220 shown in Figs. 9 and 10, the filament 225 is located about eight mm from the back of the end wall 222. The pressure in the filament chamber may be varied within a large range, for example between $10^{-2}$ and 10 Torr. This pressure will depend substantially on the diameter of the nozzle. In practice the apparatus of this invention is generally operated with a nozzle of about two mm and a pressure in the range between 0.1 and 1 Torr. If a second gas such as oxygen is supplied to the plasma confinement chamber there is generally an optimal gas flow rate relative to the power input for sustaining the gas discharges within the system. For example, for evaporation of pure metals at a power input of about two kilowatts, a gas flow of argon into the source chamber at about 0.3 cubic centimeters per second may be used. For evaporation of metal oxides, the secondary oxygen gas may be supplied at a rate of about two cubic centimeters per second.

As with any other process, it is generally required that the operating parameters of the system be varied within experimental ranges in order to establish optimum operating conditions for each particular application of the system. However, in general, for evaporation of metal oxide materials it is important that the main vacuum deposition chamber be maintained at less than about $5 \times 10^{-4}$ Torr. Such pressure in the main chamber is estimated to correspond to a pressure of about $10^{-3}$ Torr at the nozzle exit of the plasma source chamber.

This specific experimental embodiment of the apparatus of this invention has been operated to perform vacuum evaporation of a variety of evaporation source materials. Several examples of such vacuum evaporation experiments and the results thereof are discussed below.

EXAMPLE 1

A molybdenum disk target six centimeters in diameter with a thickness of 0.5 centimeters, was used as an evaporation source 166 on the cooled hearth 167. This

A-37593/HCH/LCB/40
3/30/82

evaporation source was bombarded with a plasma beam with the power supply 130 adjusted so that the voltage -V1 was 200 volts and the discharge current within the plasma confinement chamber was fifteen amps. Pure argon gas was supplied to the plasma source chamber 120. In less than three minutes of evaporation time, an opaque layer of molybdenum was deposited on glass or mylar sheets of dimension about 20 x 20 centimeters which were mounted on substrate holder 115 at about 35 centimeters distance from the evaporation source.

EXAMPLE 2

Utilizing essentially the same operating conditions as set forth in Example 1 above, with a comparable tantalum evaporation source, an opaque film of tantalum was produced on the substrate in an evaporation cycle of less than five minutes duration.

EXAMPLE 3

Crushed indium oxide was placed in a beryllium oxide crucible having a diamenter of two centimeters and a height of three centimeters. The beryllium oxide crucible was placed on the cooled copper hearth 167. The argon flow in the plasma source chamber 121 was adjusted to a minimum flow compatible with sustaining a discharge within the plasma source chamber 121 and oxygen was fed into the plasma confinement chamber 150 at a flow rate adjusted for optimal heating efficiency of the plasma. A voltage -V1 of about 150 volts and a current of ten amps was employed for the secondary discharge. A relatively thick but highly transparent layer of indium oxide was deposited on a 20 x 20 centimeter mylar sheet mounted on substrate holder 115 at a distance of 35 centimeters in less than three minutes of evaporation. The resistance of the indium oxide film was about 10 ohms per square.

EXAMPLE 4

Broken pieces of aluminum oxide were placed on the cooled copper hearth 167 and bombarded with a plasma beam generated with gas flow and source voltage parameters similar to those set forth in Example 3 above. In less than five minutes of evaporation, a highly transparent layer of aluminum oxide with a thickness of about 0.5 microns was obtained on a mylar sheet substrate at a distance of about 35 centimeters. Under essentially the same conditions a transparent film of zironium oxide was obtained in another experiment.

EXAMPLE 5

Comparative evaporations of titanium oxide were performed, first using only pure argon supplied to the source chamber 121 and a second utilizing both argon and oxygen as in Example 3 above. The deposited titanium oxide layer was absorptive with a blue color when only pure argon was utilized, but a highly transparent, clear layer of titanium oxide was produced when oxygen was supplied to the plasma confinement chamber.

EXAMPLE 6

Various metals such as iron, copper, nickel, aluminum and silicon were utilized as evaporation materials and were generally evaporated very easily with the apparatus. Some of the lighter materials such as silicon and aluminum presented a special circumstance in that they appeared to be levitated by electromagnetic forces under the impact of the plasma beam. Accordingly, they had to be clamped onto the hearth by a ring.

The specific examples given above are believed to be only a few of many possible applications for the apparatus and method of this invention.

The precise reasons for the results which are achieved by the apparatus and method of this invention are not completely understood at this time. However, it is believed that the pressure difference between the gas within the source chamber 121 and the region outside the nozzle 123, together with the electric discharge in the gas within the vicinity of the nozzle, partially activates the gas molecules which then quickly leave the source chamber 121 in a high velocity stream. The potential difference which is applied between the rear wall of the source chamber and the walls 151 of the plasma confinement chamber sustains a gas discharge within the high velocity plasma stream. At the same time the longitudinal magnetic field within the plasma confinement chamber 150 compresses the plasma beam and confines it to a narrow region of the center of the confinement chamber. As a result, it is believed that the combination of the plasma confinement action and sustained gas discharge results in bringing the gas species within the plasma to nearly complete ionization. Furthermore, confinement of the plasma apparently reduces the heat losses between the volume

A-37593/HCH/LCB/43
3/30/82

of the plasma and the walls 151 of the plasma confinement chamber which also enhances plasma activation. The ionization mechanism may also be improved by the spiraling of the electrons in the gas discharge current around the lines of force of the magnetic field within the plasma confinement chamber. It is also believed that, by injecting a second gas, such as oxygen, upstream from the sustained gas discharge within the confined plasma beam, a high activation efficiency for the second gas is achieved.

The effectiveness of the directed and focused plasma beam to induce heating of the target is believed to result from a combination of the kinetic energy of the activated gas species striking the target and the recovery of stored energy in the plasma resulting from the combination of ions and electrons in the vicinity of the target and the release of energy from excited states of atoms or molecules of the activated gas species. It is further believed that the plasma beam entering the crucible creates a dynamic pressure region thereat which is beneficial in processes involving evaporation of compounds which generally disassociate when heated. It is thought that the dynamic pressure region may favor molecular recombination of the evaporated species near the beam target. In addition, it is believed that where a second gas such as oxygen is injected into the plasma confinement chamber 150 a high yield of activated oxygen gas species is produced and, after injection into the working chamber 110, will have a long lifetime within the highly evacuated chamber. In this fashion the reactive evaporation of metal oxides to produce good quality optoelectronic films such as indium oxide and indium-tin oxide is facilitated.

A-37593/HCH/LCB/44
3/30/82

Fig. 11 shows an alternative version of apparatus in accordance with this invention particularly adapted for low pressure welding of refractory and reactive metals such as zirconium, titanium, tungsten, molybdenum, tantalum, magnesium, beryllium and various alloys of these materials. In this application the plasma beam from source chamber 280 may preferably be directed in a straight line between the nozzle 281 and the adjacent edges of the work pieces 266 and 267 to be welded. As shown in Fig. 11 a low pressure chamber 260 is provided with the interior 261 of the chamber evacuated to a pressure in the range between 1 Torr and $10^{-2}$ Torr. This pressure range can be obtained with simple mechanical vacuum pump arrangements. A viewing port 262 may be provided to chamber 260 as well as a loading port 263. An evacuation port (not shown) would also be provided for evacuating the interior 261 of chamber 260. A magnetic concentrator arrangement 285 is mounted within chamber 260 opposite the plasma source 280. A hearth 264 cooled by a cooling fluid arrangement 265 provides a platform for the work pieces 266 and 267 to be welded together. The magnetic beam concentrator arrangement 285 functions similarly to the magnetic concentrator arrangement 70 in Fig. 6 to concentrate the plasma beam into a small focused area at the adjacent regions of work pieces 266 and 267 to be welded together.

In this apparatus a plasma confinement chamber 270 defined by the interior of electromagnet coil 275 is provided. The biasing arrangements for the source chamber 280 and the walls of the vacuum evaporation chamber are similar to those provided for Fig. 6 as are the arrangements for supplying current to the electromagnet coils 275 and 286. In this apparatus a

A-37593/HCH/LCB/45
3/30/82

primary gas inlet 282 is provided for plasma source chamber 280. Provision for communicating a second gas into the plasma confinement chamber 270 is not required since reactive evaporation of metal oxide materials is not intended to be accomplished in this particular apparatus.

Fig. 12 illustrates that the general principles of this invention may also be applied in apparatus for accomplishing plasma induced, low pressure sputtering of a target material. In this apparatus a circular ring of target material 291 having a central aperature therethrough corresponding in size at least to the size of the nozzle 296 is mounted within vacuum chamber 290. An electromagnet coil 300 produces a magnetic field configuration within the chamber 290 which directs the electrons 297 within the secondary plasma discharge region above the source 291 generally toward the walls of the chamber 290. This same magnetic field configuration directs the positive ions 298 within the plasma toward the cathode on which the sputtering target 291 rests, thereby producing a sputtering of the target material with accompanying deposition of the sputtered material onto the substrate 292 disposed above the target 291. In this apparatus a noble gas such as argon may be communicated through the gas inlet 299 into the plasma source chamber 295 to be activated in the region of the filament 299 with a secondary discharge occurring between the end wall 295A of the source chamber 295 and the walls of the chamber 290 which serve as an anode.

Claims


1. A method for producing an activated gas plasma in an evacuated first chamber, c h a r a c t e r i z e d by creating an activated gas plasma in a substantially closed source chamber (20) at a gas pressure substantially greater than that of said first chamber (10);

communicating said activated gas plasma into said first chamber (10) in a high velocity stream;  and supplying an electric potential difference across a region in said first chamber (10) sufficient to produce a continuous gas discharge in said activated gas plasma.


2. The method of claim 1, c h a r a c t e r i z e d  by introducing a second gas into said first chamber (10) to be activated in said continuous gas discharge.


3. The method of any of claims 1 or 2,  c h a r a c t e r - i z e d  by

disposing a substrate (13) in said first chamber (10) in the vicinity of said continuous gas discharge

disposing an evaporation source (40) of a selected material within said first chamber (10); and

evaporating said selected material onto a surface of said substrate (13) from said evaporation source (40), said evaporated material thereby reacting with at least one constituent of said activated gas plasma to at least partially alter the physical or chemical characteristics of a thin film formed on said substrate (13).

4. The method of any of claims 1 or 2, c h a r a c t e r - i z e d  by

disposing a substrate (13) in said first chamber (10) in the vicinity of said continuous gas discharge; and

etching a surface constituent of said substrate (13) with at least one species of said activated gas plasma in said continuous  gas discharge.

5. The method of claim 1, c h a r a c t e r i z e d  in that said step of creating  said activated gas plasma comprises the steps of

introducing into said source chamber (20) a gas selected from the group consisting of argon, helium, neon, krypton, and zenon;

disposing a filament (21E) within said source chamber (20); supplying a DC electrical potential to said filament (21E) sufficient to sustain a gas discharge in said selected gas; and

supplying an AC current to said filament (21E) to heat said filament (21E) and initiate a gas discharge within said source  chamber (20).

6. The method of claim 1, c h a r a c t e r i z e d  in that said region of electrical potential difference in said first chamber (10) is adjacent said source chamber (20), and further including the steps of supplying a magnetic field of prearranged configuration within said first chamber (10) to selectively configure or direct said high velocity stream of activated gas plasma.

7. A method of reactively depositing a thin film coating on a substrate on a vacuum deposition system which includes a vacuum chamber and an evaporation source disposed in said

chamber, c h a r a c t e r i z e d by the steps of:

disposing a substantially closed source chamber (20) adjacent said vacuum chamber (10);

introducing into said source chamber (20) a gas selected from the group consisting of argon, helium, neon, krypton, and zenon, at a rate sufficient to maintain a gas pressure substantially greater than the pressure within said vacuum chamber (10);

creating an activated plasma of said selected gas in said source chamber (20);

communicating said activated gas plasma into said vacuum chamber (10) in a high velocity stream;

supplying DC electrical potential to a region within said vacuum chamber (10) in the path of said activated gas plasma stream sufficient to sustain a continuous gas discharge in said activated plasma thereat;

introducing into said vacuum chamber (10) a second gas adapted to be activated in said continuous gas discharge and to react with a selected evaporation source material to form a predetermined compound;

disposing a substrate (13) in said vacuum chamber (10) in the path of said plasma stream and in the vicinity of said continuous gas discharge; and

evaporating said selected source material to produce a source material beam directed at said substrate (13) and reacted with said activated second gas to form a thin film of said predetermined compound on said substrate (13).

8. The method of claim 7, c h a r a c t e r i z e d in that said step of creating said activated plasma comprises the steps of:

disposing a filament (21E) within said source chamber (20);

supplying a DC. electrical potential to said filament (21E) sufficient to sustain a gas discharge within said source chamber (20); and

supplying an AC electric current to said filament (21E) to heat said filament to initiate a gas discharge within said source chamber (20).

9. The method of claims 1 or 7, c h a r a c t e r i z e d in that the step of creating said activated plasma comprises the steps of:

disposing a radio frequency coil (21A) within said source chamber (20);

supplying a radio frequency signal to said coil (21A) to initiate a gas discharge; and

supplying a DC potential to said coil (21A) to sustain said gas discharge.

10. The method of claims 1 or 7, c h a r a c t e r i z e d in that the steps of creating said activated plasma comprises the steps of:

disposing a spark electrode arrangement (21C) in said source chamber;

supplying a spark voltage to said spark voltage arrangement (21C) to initiate a gas discharge; and

supplying a DC potential to said spark electrode arrangement (21C) to sustain said gas discharge.

11. An apparatus for performing the method of claims 1 or 7, c h a r a c t e r i z e d   by, in combination:

a substantially closed working chamber (10);

means for evacuating said working chamber (10) to a low pressure;

a substantially closed source chamber (20) mounted adjacent one wall (11) of said working chamber (10) and having a small-aperture nozzle (22) extending through said wall (11) to communicate gas therebetween;

means for supplying a selected gas to said source chamber (20) at a pressure substantially greater than said pressure in said working chamber 10) to produce a high velocity stream of said gas entering said working chamber (10) through said nozzle (22);

means for activating said selected gas within said source chamber (20) before exiting through said nozzle (22) so that said high velocity stream comprises activated gas molecules; and

anode means (12) disposed within said working chamber (10) in the path of said stream of activated gas molecules for producing a continuous gas discharge in said activated gas plasma.

12. The apparatus as claimed in claim 11, c h a r a c t e r - i z e d by means for supplying a preselected second gas to said working chamber (10) to be activated in said continuous gas discharge.

13. The apparatus as claimed in any of claims 11 or 12, c h a r a c t e r i z e d by substrate holder means for holding a substrate (13) in said working chamber (10) in the vicinity of said continuous gas discharge within said activated plasma; and evaporation source means (40) disposed within said working chamber (10) for evaporating a preselected material onto a surface of said substrate (13), said evaporated material thereby reacting with at least one constituent of said activated plasma to determine the physical or chemical characteristics of a thin film formed on said substrate (13).

14. The apparatus of any of claims 11 or 12, c h a r a c - t e r i z e d  by a substrate holder means for holding a substrate (13) in said working chamber (10) in the vicinity of said continuous gas discharge such that a surface constituent of said substrate (13) will be etched with said activated gas plasma in said continuous gas discharge.

15. The apparatus as claimed in claim 11, c h a r a c t e r - i z e d  in that said selected gas is selected from the group consisting of argon, helium, neon, krypton, zenon, hydrogen and nitrogen; and said means for activating said selected gas within said source chamber (20) comprises a filament (21E) mounted within said source chamber (20) in the vicinity of said nozzle (22); means for supplying a DC electrical potential between said filament (21E) and a wall of said source chamber (20) sufficient to sustain an electrical discharge in said selected gas thereat; and means for supplying an AC electrical current to said filament (21E) to heat said filament (21E) to initiate a gas discharge within said source chamber (20).

16. The apparatus of claim 11, c h a r a c t e r i z e d  in that said anode means (12) is disposed nearby said small aperture nozzle (22), and means for supplying a magnetic field within said working chamber (10) are provided to act upon said stream of activated gas molecules to selectively configure or direct said stream.

17. A vacuum deposition apparatus for reactively depositing a thin film coating on a substrate, which system includes a vacuum deposition chamber, an evaporation source disposed within said chamber, means for evacuating said chamber to a relatively low pressure, and means for holding a substrate within said vacuum deposition chamber c h a r a c t e r i z e d  by:

a substantially closed source chamber (80) mounted adjacent a wall (51) of said working chamber (50) opposite said substrate (76) and having a small-aperture nozzle (84) extending through said wall to communicate gas from said source chamber (80) to said deposition chamber (50);

means for supplying to said source chamber (80) a gas selected from the group consisting of argon, helium, neon, krypton, zenon, hydrogen and nitrogen at a pressure substantially greater than the pressure in said working chamber (50) to produce a high velocity stream of said gas entering said working chamber (50) through said nozzle (84) and directed at said substrate (76);

means for activating said selected gas within said source chamber (80) before exiting through said nozzle (84) so that said high velocity stream comprises activated gas molecules;

anode means (70) disposed within said working chamber (50) in the path of said stream of activated gas molecules and in the vicinity of said substrate (76) for producing a continuous gas discharge in said activated gas plasma;

means for supplying a second preselected gas to said vacuum deposition chamber (50), said gas being adapted to be activated in said continuous gas discharge in the vicinity of said substrate (76) and to react with a preselected evaporation source material from said evaporation source means (60) to form a thin film of a predetermined compound on said substrate (76).

18. Apparatus as claimed in claim 17, c h a r a c t e r - i z e d in that said means for activating said gas within said source chamber (80) comprises a filament (85) mounted within said source chamber (80) in the vicinity of said nozzle (84); means (100) for supplying a DC electrical potential between said filament (85) and a wall of said source chamber (80) in the vicinity of said nozzle (84), said DC electrical potential being of sufficient magnitude to sustain a gas discharge in said source chamber (80); and means for supplying an AC electric current to said filament (85) to heat said filament to initiate gas discharge within said source chamber (80).

19. Apparatus as claimed in claims 11 or 17, c h a r a c - t e r i z e d in that said means for activating said gas within said source chamber (20, 80) comprises a radio frequency coil (21A) mounted within said source chamber (20, 80) in the vicinity of said nozzle (22, 84);

means (21B) for supplying a radio frequency signal to said coil (21A) to initiate a gas discharge; and

means (21B) for supplying a DC potential between said coil (21A) and said nozzle (22, 84) of sufficient magnitude to sustain said gas discharge.

20. Apparatus as claimed in claims 11 or 17, c h a r a c - t e r i z e d in that said means for activating said gas within said source chamber (20, 80) comprises a spark electrode arrangement (21C) mounted within said chamber (20, 80) in the vicinity of said nozzle (22, 84);

means (21D) for supplying a spark initiating voltage to said electrode arrangement (21C) to initiate a gas discharge; and

means (21D) for supplying a DC potential to said electrode arrangement (21C) of sufficient magnitude to sustain said gas discharge.

21. A method for producing an activated gas plasma in an evacuated first chamber, c h a r a c t e r i z e d by:

creating an activated gas plasma in a substantially closed source chamber (120) adjacent said first chamber (110) at a gas pressure in said source chamber (120) substantially greater than that of said first chamber (110);

communicating said activated gas plasma out of said source chamber (120) as a high velocity plasma stream;

creating a longitudinal magnetic field throughout a region of substantial length to confine said high velocity plasma stream to a narrow plasma beam communicated into said first chamber (110); and

creating an electrical potential difference across a region of said confined magnetic field to produce a sustained gas discharge within said plasma beam.

22. The method of claim 21, c h a r a c t e r i z e d by selectively configuring said plasma beam into a beam of prearranged geometry and direction to impinge upon a selected target within said first chamber (110).

23. The method of claim 21, c h a r a c t e r i z e d by communicating a second gas into the plasma stream to be activated in said gas discharge region.

24. The method of claim 21, c h a r a c t e r i z e d by

disposing within said first chamber (110) a volume of material to be heated; and

creating a directing magnetic field within said first chamber (110) to direct said plasma beam onto said volume of material.

25. The method of claim 21, c h a r a c t e r i z e d  by:

disposing one or more substrates within said first chamber (110); and

directing said plasma beam to impinge upon said substrates.

26. The method of claim 21, c h a r a c t e r i z e d  by:

disposing within said first chamber (110) an evaporation source material;

disposing one or more substrates within said first chamber (110)  in a position opposite said evaporation source material; and

directing said plasma beam onto said evaporation source material to evaporate said material onto said substrates.

27. The method of claim 26, c h a r a c t e r i z e d  in that for reactive deposition of a metal oxide evaporation source material, oxygen is communicated  into the activated plasma stream to be activated in said gas discharge region.

28. A method for producing a working gas plasma in an evacuated first chamber c h a r a c t e r i z e d  by:

disposing adjacent said first chamber (110) an elongated plasma confinement chamber (150);

disposing adjacent said plasma confinement chamber (150) a substantially closed source chamber (121);

introducing into said source chamber (121) a selected gas at a rate sufficient to maintain a gas pressure within said source chamber (121) substantially greater than in said first chamber (110);

creating an activated plasma of said gas within said source chamber (121);

communicating said activated gas plasma into said plasma confining chamber (150) as a high velocity stream;

creating a longitudinal magnetic field throughout a substantial region of said plasma confinement chamber (150) to confine said high velocity plasma stream to a narrow plasma beam;

creating an electrical potential difference across a region of said confining magnetic field to produce a sustained gas discharge within said plasma beam; and

selectively directing said plasma beam into said first chamber (110) as a beam of prearranged geometry and direction.

29. The method of claim 28, c h a r a c t e r i z e d by communicating a selected second gas into said plasma confinement chamber (150) for activation of said second gas within said sustained gas discharge.

30. An apparatus for performing the method of claims 21 or 28, c h a r a c t e r i z e d by, in combination:

a substantially closed working chamber (110);

elongated plasma confinement chamber (150) disposed adjacent said working chamber (110) and having a rear gas outlet end communicating with the interior of said working chamber and a front gas inlet end;

a substantially closed source chamber (121) mounted adjacent said gas inlet end of said plasma confinement
chamber (150) and having a small aperture nozzle (123)
in a rear wall (122) thereof to communicate gas from said
source chamber (121) to said plasma confinement chamber
(150);

means for evacuating the interior of said working chamber (110) to a low pressure;

means for supplying a selected gas to said source chamber (121) at a pressure substantially greater than the
pressure within the interior of said working chamber (110)
to produce a high velocity stream of said gas through said
nozzle (123);

means for at least partially activating molecules of said
selected gas within said source chamber (121) before exiting through said nozzle (123);

means for creating an electrical potential difference across a first region of said plasma confinement chamber
(150) to produce a sustained gas discharge within said
high velocity stream of gas exiting said source chamber
(121); and

means for creating a longitudinal magnetic field within
said plasma confinement chamber (150) to confine activated molecular species of said gas to a narrow, high
velocity plasma beam.

31. The apparatus of claim 30, c h a r a c t e r i z e d   by
means for supplying a selected second gas to said plasma
confinement chamber (150) near said inlet end so that
molecules of said second gas are activated in said sustained gas discharge within said plasma confinement chamber (150).

32. The apparatus of any of claims 30 or 31, c h a r a c - t e r i z e d by means for generating within said working chamber (110) a directing magnetic field to convert said narrow plasma beam exiting said plasma confinement chamber (150) into a plasma beam of prearranged geometry and direction.

33. The apparatus of claim 32, c h a r a c t e r i z e d in that a source of preselected material to be heated positioned within said working chamber (110) and said directing means (170) comprises means (177) for directing said plasma beam onto said source.

34. The apparatus of claim 32, c h a r a c t e r i z e d in that said plasma confinement chamber (150) is located adjacent to a side-wall of said working chamber (110) intermediate a top and bottom wall (116, 111) thereof; a source material is positioned on said bottom wall (111) of said working chamber (110) and substrate positioning means (115) are provided within said working chamber (110) for positioning one or more substrates in a region of said working chamber (110) above said source material and above said plasma confinement chamber (150); and said directing means comprises a first magnetic field generating means disposed in the path of said plasma beam entering said working chamber (110) to produce a directing magnetic field pattern within said working chamber (110) and second magnetic field creating means (170) positioned adjacent said crucible (165) and selectively operative to create within said working chamber (110) a magnetic field having a first field pattern cooperating with said directing magnetic field pattern to concentrate said plasma beam on said source material or a second field pattern to deflect said plasma beam to impinge on said substrate.

35. The apparatus of claim 34, c h a r a c t e r i z e d in that said first magnetic field generating means is an electromagnet coil (160) and gimbal mounting means (162) are provided for mounting said electromagnetic coil (160) in variable axial relation to said plasma beam.

FIG.—1

FIG.—2

FIG.—3

FIG.—4

FIG.—5

FIG. —6

145 SECOND GAS SUPPLY
146
160
116
115
110
114
140 GAS SUPPLY
141
152 155
150 157
153
124
126
163
151
113
156
161
128
A.C. POWER SUPPLY
127
125
123
120
121
132
131
154
165
166
111
133 132
-V2 -VI
GND +
134
135
130 D.C. POWER SUPPLY
+ + _
136
162
176
175
176
167
168
174
171 172
170
137
177
178
173
COOL WATER SUPPLY
PUMP 169
TO VACUUM PUMP

0064288

**FIG.—7**

**FIG.—8**

FIG.—10

FIG.—9

**FIG. — 11**

GAS INLET

COOLING WATER

**FIG. — 12**

GAS INLET

European Patent Office

**EUROPEAN SEARCH REPORT**

**0064288**
Application number

EP 82103729.8

| | **DOCUMENTS CONSIDERED TO BE RELEVANT** | | **CLASSIFICATION OF THE APPLICATION (Int. Cl. ³)** |
|---|---|---|---|
| Category | Citation of document with indication, where appropriate, of relevant passages | Relevant to claim | |
| X | US – A – 3 904 505 (S. AISEN-BERG)<br><br>* Fig. 1; claims *<br><br>---- | 1,11-20,30-35 | C 23 C 11/00<br><br>C 23 C 13/00<br><br>C 23 C 15/00<br><br>H 01 J 27/08<br><br>H 01 J 27/16<br><br>H 05 H 1/26<br><br>H 05 H 3/02 |

**TECHNICAL FIELDS SEARCHED (Int.Cl. ³)**

C 23 C

H 01 J

H 05 H

**CATEGORY OF CITED DOCUMENTS**

X: particularly relevant if taken alone
Y: particularly relevant if combined with another document of the same category
A: technological background
O: non-written disclosure
P: intermediate document
T: theory or principle underlying the invention
E: earlier patent document, but published on, or after the filing date
D: document cited in the application
L: document cited for other reasons

&: member of the same patent family, corresponding document

| | | | |
|---|---|---|---|
| X | The present search report has been drawn up for all claims | | |
| Place of search | Date of completion of the search | Examiner | |
| VIENNA | 27-07-1982 | SLAMA | |

EPO Form 1503.1  06.78